# EUROPEAN PATENT APPLICATION

(11) **EP 1 848 036 A2**
(43) Date of publication of application: **24.10.2007**
(21) Application number: 07105036.3
(22) Date of filing: 27.03.2007
(51) Int. Cl.: H01L 23/373

(54) **Power module**

(30) Priority: 19.04.2006 JP 2006115823
(71) Applicant: Toyota Jidosha Kabushiki Kaisha, Toyota-shi, Aichi-ken, 471-8571 (JP); E.I. Du Pont de Nemours & Company, Wilmington, Delaware 19898 (US)
(72) Inventor: Atsumi, Takashi, Toyota-shi 471-8571 (JP); Ukai, Junzo, Toyota-shi Aichi 471-8571 (JP); Eto, Kenji, Toyota-shi Aichi 471-8571 (JP); Nakamura, Kenji, Toyota-shi Aichi 471-8571 (JP); Daiza, Sezto, Toyota-shi Aichi 471-8571 (JP); Meloni, Paul Arthur, Morristown, TN 37814 (US); Sreeram, Attignal N., Midland, MI 48640 (US); Roberts, Kurt Douglas, Raleigh, NC 27615 (US); Sutton, David Leroy, Wake Forest, NC 27587 (US)
(74) Representative: TBK-Patent

(57) **Abstract**

The mounting structure of a power device is simplified so as to reduce cost while achieving improvements in heat dissipation and reliability. A power module 100 is comprised of a metal wiring board 13, a power device 11 disposed on an upper surface of the metal wiring board 13 via a solder layer 12, a metal heat dissipating plate 15 disposed on a lower surface of the metal wiring board 13, and a heat sink 19 disposed on a lower surface of the metal heat dissipating plate 15. A resin-based insulating layer 14 is disposed between any desired two of the aforementioned layers.

## Description

### BACKGROUND OF THE INVENTION

### 1, Field of the Invention

The present invention relates to a power module capable of dissipating the heat from a power device to a heat sink efficiently.

### 2. Background Art

In recent years, semiconductor integrated circuits are used in wide areas including electronic devices, and for those devices that require a particularly large amount of electric power, a power module in which a power device is mounted is used. In such a power module, in order to dissipate the large amount of heat generated by the power device as it consumes power, a multilayer heat-dissipating structure is adopted that consists of a metal wiring board on which the power device is mounted, a ceramic insulating layer of aluminum nitride or the like, a metal heat dissipating plate, and a heat sink. Thus, in the conventional heat-dissipating structure for power modules, a ceramic insulating layer of aluminum nitride or the like is used in at least one of the layers of which the module is made up.

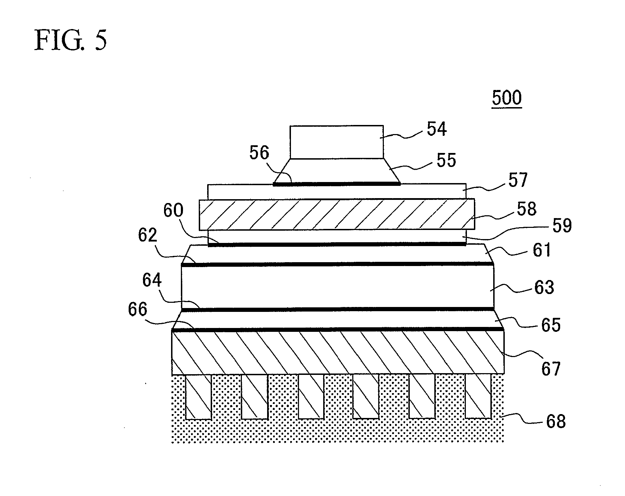

Fig. 5 shows an example of a conventional power module in which a heat-dissipating measure is taken. A power module 500 includes an IGBT chip 54, which is a power device, mounted via a first solder layer 55. On the upper and lower surfaces of an aluminum nitride insulating material 58, which is an insulating material, an aluminum wiring board 57 as a metal wiring board and an aluminum plate 59 are disposed. The first solder layer 55 is joined to an Ni plated layer 56, which is formed in such a manner as to cover the aluminum wiring board 57. The Ni plated layer is formed so as to obtain good wettability with respect to the solder layer. On the lower surface of the aluminum plate 59, a Ni plated layer 60 is formed. The Ni plated layer 60 is joined to a heat dissipating plate 63 via a second solder layer 61 and an Ni plated layer 62 formed on the lower surface of the second solder layer 61. On the lower surface of the heat dissipating plate 63, an Ni plated layer 64 is formed. The Ni plated layer 64 is thermally joined to a heat sink 67 via a third solder layer or a silicone grease layer 65 and an Ni plated layer 66. The heat sink 67 dissipates heat into cooling water 68 or to the air.

The large amount of heat generated by the IGBT chip 54, which is a power device, or the aluminum wiring board 57 is successively conducted by the first solder layer 55, the Ni plated layer 56, the aluminum wiring board 57, which is a metal wiring board, the aluminum nitride insulating material 58, which is an insulating material, the aluminum plate 59, the Ni plated layer 60, the second solder layer 61, the Ni plated layer 62, the heat dissipating plate 63, the Ni plated layer 64, the third solder layer or silicone grease layer 65, the Ni plated layer 66, and the heat sink 67, from which the heat is finally dissipated into the cooling water 68 or to the air.

Thus, the conventional power device has a standard mounting structure consisting of 14 stages, resulting in a problem of complicated manufacturing process. This results in an increase in the cost of the final product. Also, the number of the layered members is large. While it could be possible to reduce the thickness of the solder layer to several hundred µm, for example, for miniaturization purposes, the three layers of solder layers themselves do not dissipate heat well, and there are many bonded interfaces of different materials, which interfere with the dissipation of heat. Thus, there is the inconvenience that the heat generated by the power device cannot be efficiently led to the heat sink material. In addition, the conventional mounting structure of the power device is complex and might lead to a reliability problem in the module itself.

An example of a power device with such conventional heat-dissipating structure is disclosed in Patent Publication (Kokai) No. 2003-218298 A.

### SUMMARY OF THE INVENTION

In view of the aforementioned problems of conventional power devices, i.e., the complex mounting structure and high cost, and the inferior heat dissipation and reliability, it is an object of the invention to reduce cost by simplifying the mounting structure of the power device and to improve heat dissipation and reliability.

The present invention is based on the realization made by the present inventors that these problems can be solved by using a resin-based insulating material instead of the conventional ceramic insulating material.

In one aspect, the invention provides a power module comprising: a metal wiring board; a power device disposed on an upper surface of the metal wiring board via a solder layer; a metal heat dissipating plate disposed on a lower surface of the metal wiring board; and a heat sink disposed on a lower surface of the metal heat dissipating plate. The power module further comprises a resin-based insulating layer disposed between any two of the aforementioned layers.

A basic form of the power module of the invention is the following:
(1) A power module comprising, from top to bottom thereof: a power device; a metal wiring board disposed on a lower surface of the power device via a solder layer; a metal heat dissipating plate disposed on a lower surface of the metal wiring board via a resin-based insulating layer; and a heat sink disposed on a lower surface of the metal heat dissipating plate via solder or silicone grease (preferably an Ni plated layer is provided on a lower surface of the metal heat dissipating plate and on an upper surface of the heat sink). Thus, the structure is simplified to a 9-stage structure. When a ceramic insulating layer is used, a solder layer is required for bonding with another layer, and an Ni plated layer needs to be formed on the solder layer. However, in accordance with the invention, such Ni plated layer is either not required at all or required in small numbers. Further, the invention requires two stages of the solder layers at most, and the metal wiring board may be comprised of an inexpensive, low-electric-resistance material such as copper or aluminum. In addition, the metal wiring board and the metal heat-dissipating plate can be joined by a resin-based insulating material using a simple means such as thermocompression bonding, for example. Thus, the heat-dissipating structure of the module is greatly simplified, so that cost reduction and improvements in the reliability of the module can be achieved.
   The above is the basic form of the power module of the invention. The invention also includes the following variations (2) to (4).
(2) A structure based on the aforementioned conventional structure in which the ceramic insulating material is replaced with a resin-based insulating material. Specifically, a power module comprising, from top to bottom thereof: a power device; a metal wiring board disposed on a lower surface of the power device via a solder layer; a metal plate disposed on a lower surface of the metal wiring board via a resin-based insulating layer; a metal heat dissipating plate disposed on a lower surface of the metal plate; and a heat sink disposed on a lower surface of the metal heat dissipating plate via a solder or silicone grease layer.
(3) A structure in which the wiring board and the heat-dissipating plate of the above basic structure are combined. Specifically, a power module comprising, from top to bottom thereof: a power device; a metal wiring board/metal heat dissipating plate disposed on a lower surface of the power device via a solder layer; a metal plate disposed on a lower surface of the metal wiring board/metal heat dissipating plate via a resin-based insulating layer; and a heat sink disposed on a lower surface of the metal plate via a solder or silicone grease layer.
(4) A structure in which the heat sink and the heat-dissipating plate of the basic structure are combined. Specifically, a power module comprising, from top to bottom thereof: a power device; a metal wiring board disposed on a lower surface of the power device via a solder layer; and a heat sink/metal heat dissipating plate disposed on a lower surface of the metal wiring board via a resin-based insulating layer.

In the power modules (2) to (4), preferably an Ni plated layer is provided in contact with the solder layer.

The inventors have also found that levels of insulation and thermal conductivity comparable to those of the conventional structure can be obtained by selecting a film thickness within a specific range in consideration of the insulation value and heat conductivity required of the aforementioned resin-based insulating material. Specifically, the resin-based insulating material used in the invention is preferably comprised of a resin material having a breakdown voltage of 60 to 300 kV/mm and a heat conductivity of 0.5 to 2.5 W/K·m. Further, in the power module of the invention, preferably the film thickness of the resin-based insulating layer is 10 to 50 µm. In this respect, the invention greatly differs from the conventional structure where the ceramic insulating layer has a thickness of 600 µm to 1 mm.

A preferable example of the resin-based insulating material used in the invention is a thermoplastic polyimide resin. Particularly, by using a thin film of thermoplastic polyimide material that satisfies the aforementioned properties in the insulating layer, the high insulation property and heat resistance of the polyimide material can be taken advantage of. In this way, polyimide materials, which have heretofore been difficult to use as a power device mounting material due to their high heat resistance (i.e., low heat conductivity) as compared with ceramic materials, can be used in the heat-dissipating structure for a power module.

A preferable example of a power device to which the power module of the invention can be applied is an IGBT (intelligent bipolar transistor) chip. An example of a power module is an inverter module.

In a second aspect, the invention provides a hybrid vehicle equipped with the above inverter module. Because the heat-dissipating structure can be greatly simplified, cost reduction can be achieved and the reliability of the module can be improved, thus promoting the mounting of such power module on hybrid vehicles.

In accordance with the invention, a resin-based insulating material is used in the heat-dissipating structure of a power module instead of the conventional ceramic insulating material. The use of a resin-based insulating material simplifies the mounting structure of the power device and leads to cost reduction, while achieving improvements in heat dissipation and the reliability of the module. Generally, resin-based insulating materials are inferior to ceramic insulating materials in terms of heat conductivity; however, when formed in a thin film so as to improve heat conductivity, the former can replace the latter.

### BRIEF DESCRIPTION OF THE DRAWINGS

Fig. 1 shows a schematic cross section of a basic form of the power module according to the invention.
Fig. 2 shows a schematic cross section of a variation of the power module according to the invention.
Fig. 3 shows a schematic cross section of a variation of the power module according to the invention.
Fig. 4 shows a schematic cross section of a variation of the power module according to the invention.
Fig. 5 shows a schematic cross section of a conventional power module.

### DESCRIPTION OF THE PREFERRED EMBODIMENTS OF THE INVENTION

In the following, embodiments of the power module according to the invention will be described, together with its heat-dissipating structure, with reference to the drawings.

### Embodiment 1

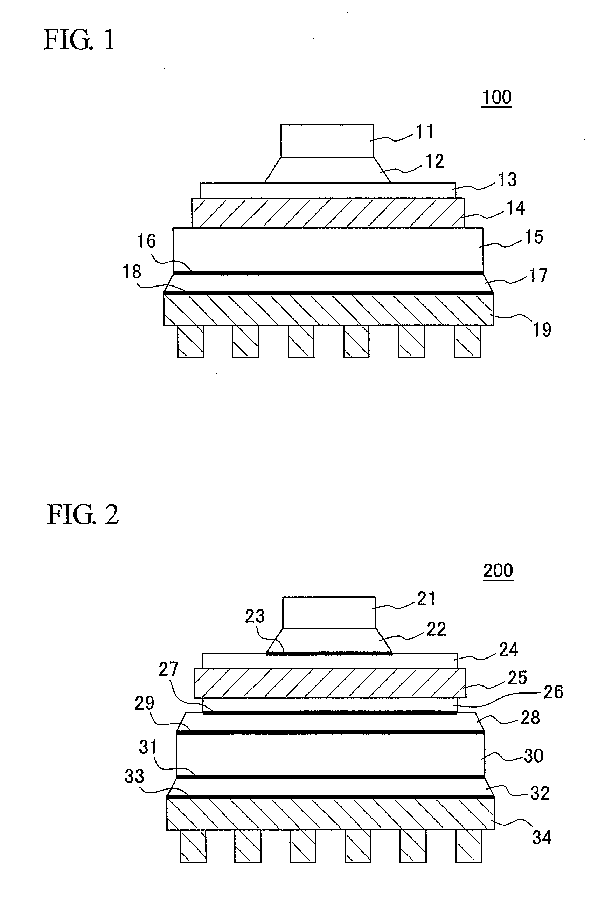

Fig. 1 shows a schematic cross section of a basic form of the power module according to the invention. A power module 100 is a 9-stage power module comprised of, from top to bottom: a power device 11 such as an IGBT chip; a metal wiring board 13 disposed on the lower surface of the power device 11 via a first solder layer 12; a metal heat dissipating plate 15 disposed on the lower surface of the metal wiring board 13 via a resin-based insulating layer 14 of thermoplastic polyimide or the like; an Ni plated layer 16 formed on the lower surface of the metal heat dissipating plate 15; a solder layer or a silicone grease layer 17; an Ni plated layer 18; and a heat sink 19, on which the Ni plated layer 18 is formed.

The heat generated by the IGBT chip is conducted by the individual layers before it is dissipated via the heat sink into water or to the air.

It is noted that instead of the conventional metal heat dissipating plate made of Cu-Mo or the like, which is relatively expensive, the present invention also advantageously allows the use of a metal heat dissipating plate made of Cu, which is inexpensive and of which there is not much price fluctuations.

### Embodiment 2

Fig. 2 shows a schematic cross section of a variation of the power module according to the invention. In this embodiment, the ceramic insulating material of the conventional structure is replaced by a resin-based insulating material. Specifically, a power module 200 is comprised of, from top to bottom: a power device 21 such as an IGBT chip; a first solder layer 22 disposed on the lower surface of the power device 21; an Ni plated layer 23; a metal wiring board 24; a metal plate 26 disposed on the lower surface of the metal wiring board via a resin-based insulating layer 25; an Ni plated layer 27; a second solder layer 28; an Ni plated layer 29; a metal heat dissipating plate 30; an Ni plated layer 31; a third solder layer or a silicone grease layer 32; and a heat sink 34 disposed via an Ni plated layer 33.

As in Embodiment 1, the heat generated by the IGBT chip is conducted by the individual layers before it is dissipated via the heat sink into water or to the air.

### Embodiment 3

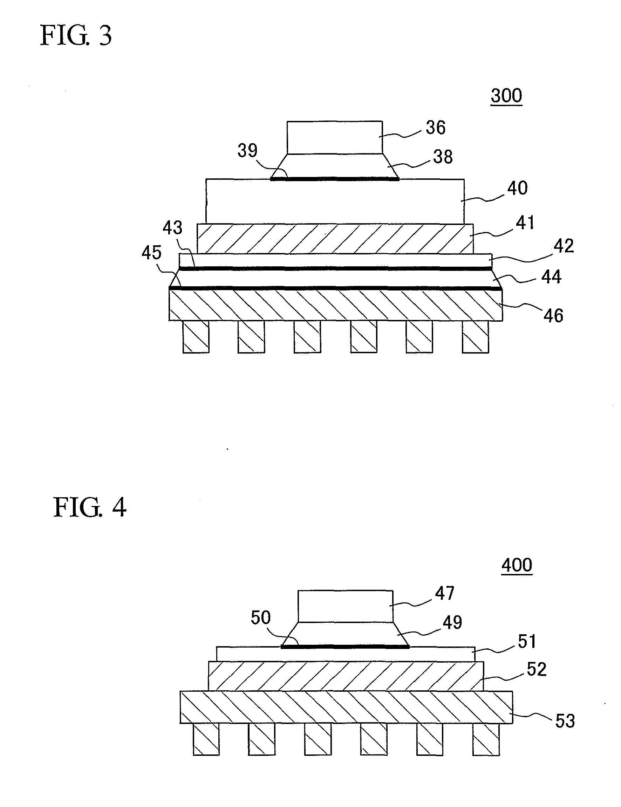

Fig. 3 shows a schematic cross section of another variation of the power module according to the invention. In this embodiment, the wiring board and the heat dissipating plate of the foregoing basic structure are combined. Specifically, a power module 300 includes, from top to bottom: a power device 36 such as an IGBT chip; a metal wiring board/metal heat dissipating plate 40 disposed on the lower surface of the power device 36 via a first solder layer 38 and an Ni plated layer 39; a metal plate 42 disposed on the lower surface of the metal wiring board/metal heat dissipating plate 40 via a resin-based insulating layer 41; an Ni plated layer 43 disposed on the lower surface of the metal plate 42; a third solder layer or a silicone grease layer 44; and a heat sink 46 disposed via an Ni plated layer 45.

As in Embodiment 1, the heat generated by the IGBT chip is conducted by the individual layers and before it is dissipated via the heat sink into water or to the air.

### Embodiment 4

Fig. 4 shows a schematic cross section of another variation of the power module of the invention. In the present embodiment, the heat sink and the heat dissipating plate of the foregoing basic structure are combined. Specifically, a power module 400 is comprised of, from top to bottom: a power device 47 such as an IGBT chip; a first solder layer 49 disposed on the lower surface of the power device 47; a metal wiring board 51 disposed via an Ni plated layer 50; and a heat sink/metal heat dissipating plate 53 disposed on the lower surface of the metal wiring board 51 via a resin-based insulating layer 52.

As in Embodiment 1, the heat generated by the IGBT chip is conducted by the individual layers before it is dissipated via the heat sink into water or to the air.

The problems of prior art that are solved by the invention include the following. First, with regard to the issue of bonding between the individual layers, the present invention does not require soldering for the bonding with the lower heat dissipating plate or the like. Therefore, no metal plate is required at the bottom of the insulating material. Furthermore, the type of metal that can be bonded to the resin insulating material, such as polyimide, is not limited to aluminum but may be Cu or other general-purpose metal. In this respect, the invention offers another advantage that metals having high wettability, such as Cu, do not require Ni plating.

Next, with regard to the issue of thermal expansion in the individual layers, a thin film of thermoplastic polyimide material has a very low Young's modulus such that it does not break when subjected to bending stress but instead absorbs the bending stress, thus preventing the device from being affected by such stress. Thus, the invention offers the advantage that the heat dissipating plate can be made of a general-purpose metal that has high thermal expansion and is inexpensive, such as copper or aluminum.

In the following, thermoplastic polyimide suitable as a resin-based insulating material for the invention will be described.

In accordance with the present invention, the thermoplastic polyimide is preferably an aromatic polyimide. Aromatic polyimides are a condensation product of an aromatic tetracarboxylic acid with an aliphatic or aromatic diamine. They are typically obtained by producing an amide acid by the condensation polymerization of tetracarboxylic acid dianhydride, such as pyromellitic acid dianhydride or biphenyltetracarboxylic acid dianhydride, and diamine, such as paraphenylene diamine or diaminodiphenyl ether, followed by ring-closing curing by heat or a catalyst. Such thermoplastic polyimide can be obtained by copolymerization of the following compounds, for example.

Examples of dicarboxylic anhydride include: pyromellitic acid dianhydride; 4,4'-oxydiphthalic acid dianhydride; 3,3',4,4'-benzophenonetetracarboxylic acid dianhydride; 3,3',4,4'-biphenyltetracarboxylic acid dianhydride; 2,2',3,3'biphenyltetracarboxylic acid dianhydride; 2,2'-bis(3,4-dicarboxyphenyl)hexafuluoropropane dianhydride; bis(3,4-dicarboxyphenyl)sulfone dianhydride; bis(3,4-dicarboxyphenyl)sulfide dianhydride; bis(2,3-dicarboxyphenyl)methane dianhydride; bis(3,4-dicarboxyphenyl)methane dianhydride; 1,1-bis(2,3-dicarboxyphenyl)methane dianhydride; 1,1-bis(2,3-dicarboxyphenyl)propane dianhydride; 2,2-bis(3,4-dicarboxyphenyl)propane dianhydride; and m-phenylenebis (trimellitic acid)dianhydride; 2,2'-bis[4-(3,4-dicarboxyphenoxy)phenyl]propane dianhydride.

Examples of diamine include: hexamethylenediamine; heptamethylenediamine; 3,3'-dimethylpentamethylene diamine; 3-methylhexamethylenediamine; 3-methylheptamethylenediamine; 2,5-dimethylhexamethylenediamine; octamethylenediamine; nonamethylenediamine; 1,1,6,6-tetramethylhexamethylenediamine; 2,2,5,5-tetramethylhexamethylenediamine; 4,4-dimethylheptamethylenediamine; decamethylenediamine; m-phenylenediamine; 4,4'-diaminobenzophenone; 4-aminophenyl-3-aminobenzoate; m-aminobenzoil-p-aminoanilide; 4,4'-diaminodiphenyl ether; 3,4'-diaminodiphenyl ether; bis(4-aminophenyl)methane; 1,1-bis(4-aminophenyl)ethane; 2,2-bis(4-aminophenyl)propane; 2,2'-bis[4-(4-aminophenoxy)phenyl)]propane; 4,4'-diaminodiphenyl sulfoxide; 3,3'-diaminobenzophenone; 1,3-bis(4-aminophenoxy)benzene; 2,2'-diaminobenzophenone; 1,2-bis(4-aminophenoxy)benzene; 1,3-bis(4-aminobenzoyloxy)benzene; 4,4'-dibenzanilide; 4,4'-bis(4-aminophenoxy)diphenylether; 2,2'-bis(4-aminophenyl)hexafluoropropane; 4,4'-diaminodiphenylsulfone; 1,12-diaminododecane; 1,16- diaminohexadecane; and polysiloxanediamine; 1,3-bis(3-aminobenzoyloxy)benzene; 1,4-bis(4-aminophenoxy)benzene; 4,4-bis(4-aminopheoxy)biphenyl; 4,4-bis(4-aminophenoxy)diphenylsulfone; 4,4-bis(3-aminophenoxy)diphenylsulfone; 2,2-bis(4-[4-aminophenoxy]phenyl)-1,1,1,3,3,3-hexafluoropropane; 3,3'-diaminophenylsulfone; and p-phenylenediamine.

Of the above compounds, particularly preferable as a thermoplastic polyimide used in the present invention are a copolymer of 1,3-bis(4-aminophenoxy)benzene (abbreviated as RODA), pyromellitic acid dianhydride (abbreviated as PMDA), and 4,4'-oxydiphthalic acid dianhydride (ODPA), a copolymer of 4,4'-diaminodiphenyl ether (abbreviated as ODA) and 3,3'4,4'-biphenyltetracarboxylic acid dianhydride (abbreviated as BPDA), a copolymer of ODA, PMDA, and BPDA, and a copolymer of 3,3', 4,4'-benzophenonetetracarboxylic acid dianhydride (BTDA), PMDA, and 2,2'-bis[4-(4-aminophenoxy)phenyl)]propane (abbreviated as BAPP).

In accordance with the invention, the glass transition temperature of the thermoplastic polyimide, which is softened when heated, is from 200°C to 350°C and more preferably from 210°C to 300°C.

In accordance with the invention, by using a resin-based insulating material in the heat-dissipating structure of a power module instead of the conventional ceramic insulating material, the mounting structure of the power device can be simplified and a cost reduction can be achieved and, in addition, improvements in heat dissipation and the reliability of the module can be achieved. By equipping a hybrid automobile with the aforementioned inverter module, widespread use of hybrid vehicles can be promoted. The mounting structure of a power device is simplified so as to reduce cost while achieving improvements in heat dissipation and reliability. A power module 100 is comprised of a metal wiring board 13, a power device 11 disposed on an upper surface of the metal wiring board 13 via a solder layer 12, a metal heat dissipating plate 15 disposed on a lower surface of the metal wiring board 13, and a heat sink 19 disposed on a lower surface of the metal heat dissipating plate 15. A resin-based insulating layer 14 is disposed between any desired two of the aforementioned layers.

## Claims

1. A power module comprising:
a metal wiring board;
a power device disposed on an upper surface of the metal wiring board via a solder layer;
a metal heat dissipating plate disposed on a lower surface of the metal wiring board; and
a heat sink disposed on a lower surface of the metal heat dissipating plate,
the power module further comprising a resin-based insulating layer disposed between any desired two of the aforementioned layers.

2. The power module according to claim 1, comprising:
a power device;
a metal wiring board disposed on a lower surface of the power device via a solder layer;
a metal heat dissipating plate disposed on a lower surface of the metal wiring board via a resin-based insulating layer, and
a heat sink disposed on a lower surface of the metal heat dissipating plate via solder or silicone grease.

3. The power module according to claim 1, comprising:
a power device;
a metal wiring board disposed on a lower surface of the power device via a solder layer;
a metal plate disposed on a lower surface of the metal wiring board via a resin-based insulating layer;
a metal heat dissipating plate disposed on a lower surface of the metal plate; and
a heat sink disposed on a lower surface of the metal heat dissipating plate via a solder or silicone grease layer.

4. The power module according to claim 1, comprising:
a power device;
a metal wiring board/metal heat dissipating plate disposed on a lower surface of the power device via a solder layer;
a metal plate disposed on a lower surface of the metal wiring board/metal heat dissipating plate via a resin-based insulating layer; and
a heat sink disposed on a lower surface of the metal plate via a solder or silicone grease layer.

5. The power module according to claim 1, comprising:
a power device;
a metal wiring board disposed on a lower surface of the power device via a solder layer; and
a heat sink/metal heat dissipating plate disposed on a lower surface of the metal wiring board via a resin-based insulating layer.

6. The power module according to any one of claims 1 to 5, wherein the resin-based insulating layer is made of a resin material having a breakdown voltage of 60 to 300 kV/mm and a heat conductivity of 0.5 to 2.5 W/K·m.

7. The power module according to any one of claims 1 to 6, wherein the film thickness of the resin-based insulating layer is from 10 to 50 µm.

8. The power module according to any one of claims 1 to 7, wherein the resin-based insulating layer is made of thermoplastic polyimide.

9. The power module according to any one of claims 1 to 8, wherein the power device comprises an IGBT chip.

10. The power module according to any one of claims 1 to 9, wherein the power module is an inverter module.

11. A hybrid vehicle equipped with the inverter module according to claim 10.
